# EUROPEAN PATENT APPLICATION

(11) **EP 3 866 342 A1**
(43) Date of publication of application: **18.08.2021**
(21) Application number: 20157334.2
(22) Date of filing: 14.02.2020
(51) Int. Cl.: H03K 5/24

(54) **LOW-POWER CONSUMPTION COMPARATOR AND METHOD FOR COMPARISON**

(71) Applicant: Imec VZW, 3001 Leuven (BE)
(72) Inventor: Garakoui, Seyed Kasra, 3001 Leuven (BE)
(74) Representative: Körfer, Thomas

(57) **Abstract**

A comparator (1) for comparing a first input signal (V_{INSH}) to a second input signal (V_{DAC}) is provided. The comparator (1) comprises a differential amplifier (11) which is adapted to amplify a difference between a first amplifier signal and a second amplifier signal. Moreover, the comparator (1) comprises a capacitor device (12), adapted to charge to a differential capacitor voltage based upon the amplified difference between the first amplifier signal and the second amplifier signal. The capacitor device (12) therein comprises an adaptive capacitance.

## Description

The invention relates to a comparator and a method for comparing two input signals, especially for use in analogue to digital converters.

In analogue to digital converters, especially successive-approximation analogue to digital converters, noise is a main bottleneck. There is a trade-off between power consumption and noise susceptibility. For the price of a high power consumption, noise susceptibility can be reduced. This can especially be achieved by using a large capacitor for storing the output signal of a differential pre-amplifier amplifying the two input signals to be compared.

For example, the document "A 1.2-V Dynamic Bias Latch-Type Comparator in 65-nm CMOS With 0.4-mV Input Noise", IEEE Journal of Solid-State Circuits, Vol. 53, No. 7, pages 1902-1912, July 2018, shows a low-noise comparator, which has such a high power consumption. This is especially problematic in mobile applications.

Accordingly, the object of the invention is to provide a comparator and a method for comparing signals, which allow for a low power consumption.

The object is solved by the features of the independent claims. Additional features of the invention are provided in the dependent claims. In the following, parts of the description and drawings referring to embodiments which are not covered by the claims are not presented as embodiments of the invention, but as examples useful for understanding the invention.

According to a first aspect of the invention, a comparator for comparing a first input signal to a second input signal is provided. The comparator comprises a differential amplifier which is adapted to amplify a difference between a first amplifier signal and a second amplifier signal. Moreover, the comparator comprises a capacitor device, adapted to charge to a differential capacitor voltage based upon the amplified difference between the first amplifier signal and the second amplifier signal. The capacitor device therein comprises an adaptive capacitance. It is thereby possible to alternate between a low-noise high-power consumption operating mode and a high-noise low-power consumption operating mode, by alternating between a high capacitance and a low capacitance. It should be noted that although an amplifier is specified here, this amplifier is comparable in its function to a pre-amplifier.

According to an example, the first amplifier signal is the first input signal or a signal based on the first input signal, and the second amplifier signal is the second input signal, or a signal derived therefrom. This allows for a very simple circuit design.

According to an example, the comparator comprises a latch, connected to the differential amplifier. The latch is adapted to trigger, when an absolute value of either of capacitor voltages forming the differential capacitor voltage exceeds a trigger threshold, and after triggered, indicate with a differential latch output signal if the differential capacitor voltage was positive or negative.

Advantageously and according to an example, the differential amplifier is adapted to charge the capacitor device to a positive differential capacitor voltage, if the first pre-amplifier signal is larger than the second pre-amplifier signal, and a negative differential capacitor voltage, if the second pre-amplifier signal is larger than the first pre-amplifier signal. The latch is the adapted to output a positive differential latch output signal, if the differential capacitor voltage is positive and if the absolute value of either of the capacitor voltages is above the trigger threshold, and output a negative differential latch output signal, if the differential capacitor voltage is negative and if the absolute value of either of the capacitor voltages is above the trigger threshold. Also, this allows for a very simple circuit design.

According to an example, the comparator comprises an offset device, adapted to provide an offset signal to the differential amplifier. This allows for a very simple detection of the level of difference between the input signals.

Advantageously and according to an example, in a first operation mode, the capacitor device is adapted to set the adaptive capacitance to a first value. The offset device is adapted to add the offset signal to the first input signal resulting in the first amplifier signal. In this first operation mode, the comparator is adapted to output a negative output signal, if the differential latch output signal is negative. This allows for a very quick and low power determination, if the first input signal is smaller than the second input signal.

Advantageously and according to an example, when in the first operation mode, the comparator is adapted to enter a second operation mode, if the differential latch output signal is positive. In this case, when in the second operation mode, the capacitor device is adapted to set the adaptive capacitance to the first value, and the offset device is adapted to subtract the offset signal from the first input signal, resulting in the first amplifier signal. The comparator is then adapted to output a positive output signal, if the differential latch output signal is positive. Also, this allows for a very quick and low power determination that the first input signal is larger than the second input signal.

Advantageously and according to an example, while in the second operation mode, the comparator is adapted to enter a third operation mode, if the differential latch output signal is negative. In this third operation mode, the capacitor device is adapted to set the adaptive capacitance to a second value, larger than the first value, the offset device is adapted to provide the offset signals so that it cancels out, resulting in the first amplifier signal being the first input signal. In this case, the comparator is adapted to output a positive output signal, if the differential latch output signal is positive, and output a negative output signal, if the differential latch output signal is negative. This allows for a very accurate determining which of the input signals is larger, if the values are close together.

Advantageously, in the third operation mode, the capacitor device is adapted to set the adaptive capacitance to a second value, larger by at least 50%, preferably 100%, most preferably 200%, than the first value. This allows for an increasing accuracy at the cost of increasing power consumption.

Advantageously, the capacitor device comprises at least a first capacitor, at least a second capacitor, and at least a switch. The capacitor device is adapted to change its capacity between a first value and a second value by opening and closing the at least one switch. This allows for a very simple circuit design of the capacitor device. It should be noted that in a differential setup, the capacitor device preferable comprises a first capacitor pair instead of the above-mentioned first capacitor, a second capacitor pair instead of the above-mentioned second capacitor, and a pair of switches instead of the above-mentioned at least one switch.

According to an example, the offset device comprises a first current source, adapted to input a first bias current, and a second current source, adapted to input a second bias current, the second bias current being of an identical value as the first bias current. The offset device moreover comprises at least one offset switch, preferably an offset-switch-set in a Pi configuration. Moreover, the offset device comprises at least one offset resistor. The offset device is adapted to selectively produce a positive offset signal, a negative offset signal, and a canceled out offset signal. This allows for a simple construction of the offset device.

According to an example, the offset device is adapted to, in the first operating mode, provide the first bias current and the second bias current to the differential amplifier both in a first direction, resulting in the offset signal being added to the first input signal, resulting in the positive offset signal.

The offset device is adapted to, in the second operating mode, provide the first bias current and the second bias current to the differential amplifier, both in a second direction, resulting in the offset signal being subtracted from the first input signal, resulting in the negative offset signal.

The offset device is moreover adapted to, in the third operating mode, provide the first bias current to the differential amplifier in the first direction, provide the second bias current to the differential amplifier in the second direction, resulting in a voltage drop across the at least one offset resistor of the first bias current and a voltage drop across the at least one offset resistor of the second bias current cancelling each other out, resulting in the canceled out offset signal.

This allows for a very simple circuit design achieving a simple switch of the offset signal between a first direction, a second direction and not being input at all.

According to a second aspect of the invention, an analogue to digital converter is provided. This converter comprises a comparator as described before. The analogue to digital converter advantageously is a successive approximation analogue to digital converter, or a flash analogue to digital converter, or a sigma delta analogue to digital converter. This allows for a very low power operation of the analogue to digital converter.

According to a third aspect of the invention, a device comprising a herein described analogue to digital converter. The device is a biomedical sensor device or a mobile communications device. This allows for a very low power operation of the device.

According to a fourth aspect of the invention, a method for comparing a first input signal to a second input signal is provided. The method has the following steps: amplifying a difference between a first amplifier signal and a second amplifier signal, and charging a capacitor device to a differential capacitor voltage based upon the amplified difference between the first amplifier signal and the second amplifier signal. The method moreover comprises adaptively changing the capacitance of the capacitor device. This allows for a very low power comparison of the signals.

Example embodiments of the invention are now further explained with respect to the drawings, in which
- Fig. 1: shows a block diagram of an example successive-approximation analogue to digital converter;
- Fig. 2: shows a first embodiment of the comparator, including an amplifier and a latch, in a block diagram;
- Fig. 3: shows a circuit diagram of a detail of a second embodiment of the comparator, especially an amplifier;
- Fig. 4: shows a circuit diagram of a detail of a third embodiment of the comparator, especially a latch;
- Fig. 5: shows a voltage range of signals in a third embodiment of the comparator;
- Fig. 6a: shows a circuit diagram of a fourth embodiment of the comparator in a first operating mode;
- Fig. 6b: shows an equivalent circuit diagram of the fourth embodiment of the comparator;
- Fig. 7a: shows a fifth embodiment of the comparator in a second operating mode;
- Fig. 7b: shows an equivalent circuit diagram of the fifth embodiment of the comparator;
- Fig. 8a: shows a sixth embodiment of the comparator in a third operating mode;
- Fig. 8b: shows an equivalent circuit diagram of the sixth embodiment of the comparator, and
- Fig. 9: shows a flow diagram of an embodiment of the method.

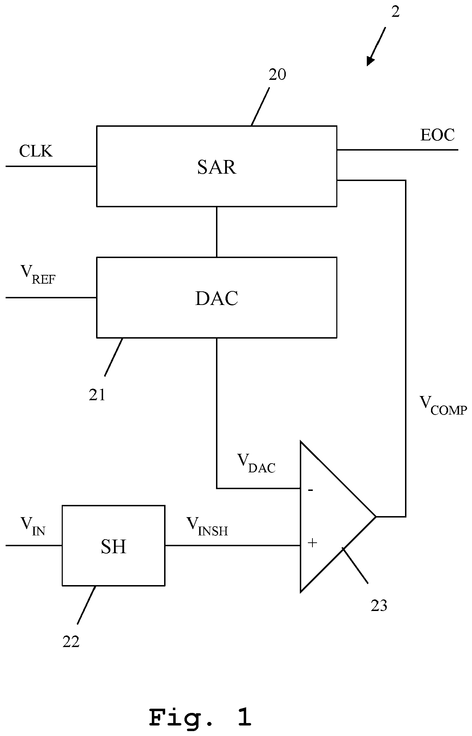

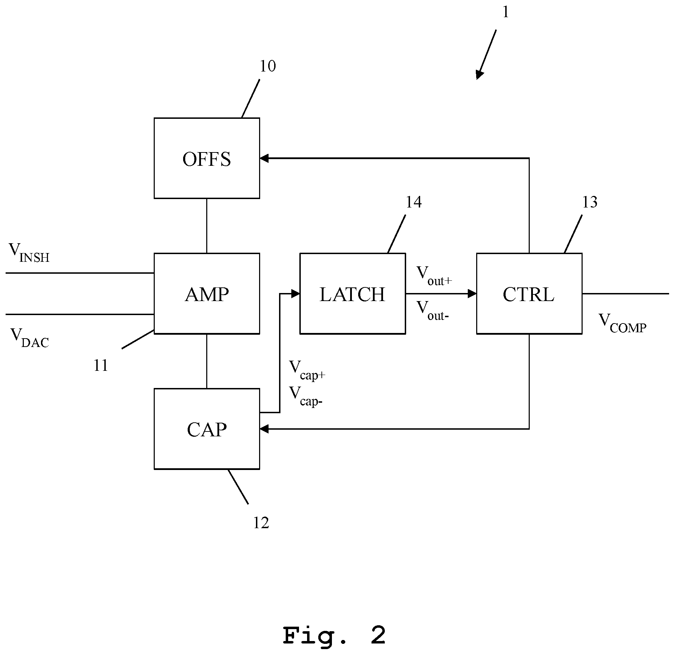

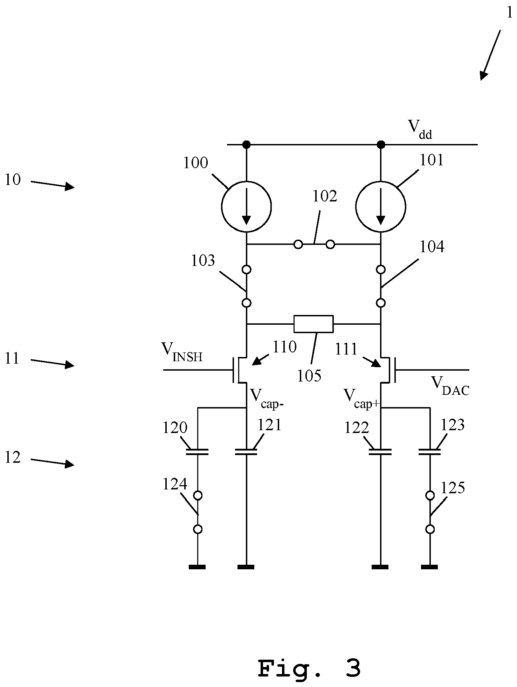

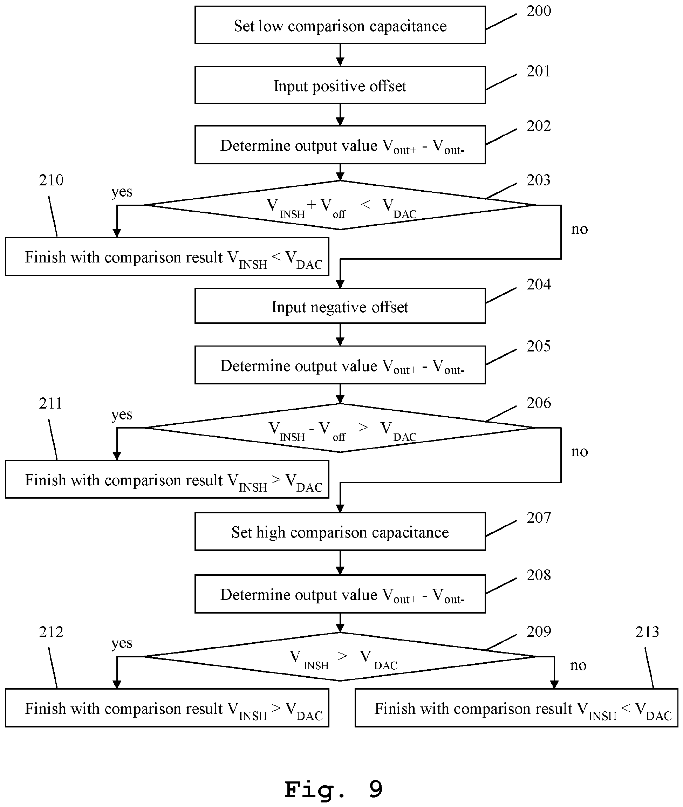

First, we demonstrate the general function of a successive-approximation analogue to digital converter along Fig. 1. With regard to Fig. 2, the general function and construction of an embodiment of the comparator is shown. Along Fig. 3 - Fig. 8b, further details of the construction and function of different embodiments of the comparator are described. With regard to Fig. 9, the function of an embodiment of the method is described in detail. Similar entities and reference numbers in different figures have been partially omitted.

In Fig. 1, an example successive-approximation analogue to digital converter 2 is shown. It comprises a successive-approximation register 20 connected to a digital-analog-converter 21, which is connected to a negative input of a comparator 23. The successive-approximation analogue to digital converter 2 moreover comprises a sample-hold circuit 22, which is connected to a positive input of the comparator 23. An output of the comparator 23 is moreover connected to the successive-approximation register 20. The successive-approximation register 20 is provided with a clock signal CLK. The digital-analog-converter 21 is provided with a reference signal V_{REF}. The sample-hold circuit 22 is provided with an input voltage V_{IN}.

In operation, the sample-hold circuit 22 samples and holds a present value of the input signal V_{IN} and outputs it as sample-hold signal V_{INSH}. This signal is provided to the comparator 23. The comparator 23 compares this sample-hold signal V_{INSH} to a digital-analog-converter signal V_{DAC}. This signal is provided by the digital-analog-converter 21, controlled by the successive-approximation register 20.

Especially, the successive-approximation register 20 provides a digital value to the digital-analog-converter 21, which instructs the digital-analog-converter 21 on the level of the digital-analog-converter signal V_{DAC}.

In the beginning of the operation, an arbitrary value, usually in the middle of a range of values is chosen. The comparison result is output by the comparator 23 as comparator signal V_{COMP}. This signal is positive, if the sample-hold signal V_{INSH} is larger than the digital-analog-converter signal V_{DAC} and negative, if the digital-analog-converter signal V_{DAC} is larger than the sample-hold signal V_{INSH} .

The signal is provided to the successive-approximation register 20, which based upon this signal then sets a new control signal for the digital-analog-converter 21. Especially, in each iteration, the successive-approximation register 20 reduces the distance to the sample-hold signal V_{INSH}, by halving the distance between the two closest boarder values.

The reference signal V_{REF} is used by the digital-analog-converter 21 to achieve a very accurate output signal level. The clock signal CLK is used by the successive-approximation register 20 for timing purposes.

As soon as the successive approximation is completed, the successive-approximation register 20 outputs a signal EOC, which indicates the end of conversion. The last value V_{DAC} is a very close approximation of the input signal V_{IN} at the moment of sampling by the sample-hold circuit 22. Since a successive-approximation analogue to digital converter is a well-known component, further details regarding its function are omitted here.

In Fig. 2, a block diagram of the inventive comparator 1 is shown. The inventive comparator 1 can be used instead of the comparator 23 in a conventional successive-approximation analogue to digital converter, resulting in an inventive successive-approximation analogue to digital converter. Since the block diagram of the inventive successive-approximation analogue to digital converter does not differ from the block diagram shown in Fig. 1, it is not separately shown.

The comparator 1 of Fig. 2 comprises an offset device 10, connected to a differential amplifier 11, which in turn is connected to a capacitor device 12. Furthermore, it comprises a latch 14, which is connected to the capacitor device 12. Moreover, the offset device 10, the latch 14 and the capacitor device 12 are all connected to a controller 13, which controls the operation of the individual devices.

The differential amplifier 11 is provided with a first input signal, for example the sample-hold signal V_{INSH} of Fig. 1 and a second input signal, for example the digital-analog-converter signal V_{DAC} of Fig. 1. The differential amplifier 11 amplifies the difference V_{DIFF} between a first amplifier signal and a second amplifier signal, and accordingly charges the capacity of the capacitor device 12. This results in a differential capacitor voltage V_{cap+}, V_{cap-} stored by the capacitor device 12. If the differential capacitor voltage V_{cap+} - V_{cap-} is positive, the first amplifier signal is larger than the second amplifier signal, while a negative value indicates that the second amplifier signal is larger than the first amplifier signal. The latch 14 triggers when the voltage of one of the capacitors of the capacitor device 12 (single ended) reaches a certain threshold. A differential latch output signal Vₒᵤₜ₊, Vₒᵤₜ₋ indicates if the differential voltage at the output of the amplifier was positive or negative.

The capacitor device 12 comprises an adaptive capacitance. This capacity can be changed by the controller 13. The capacitance can be changed between at least two fixed values. A first capacity value is smaller than a second capacity value. Also, a switching between more than two different capacity values, using for example a switch-set is possible.

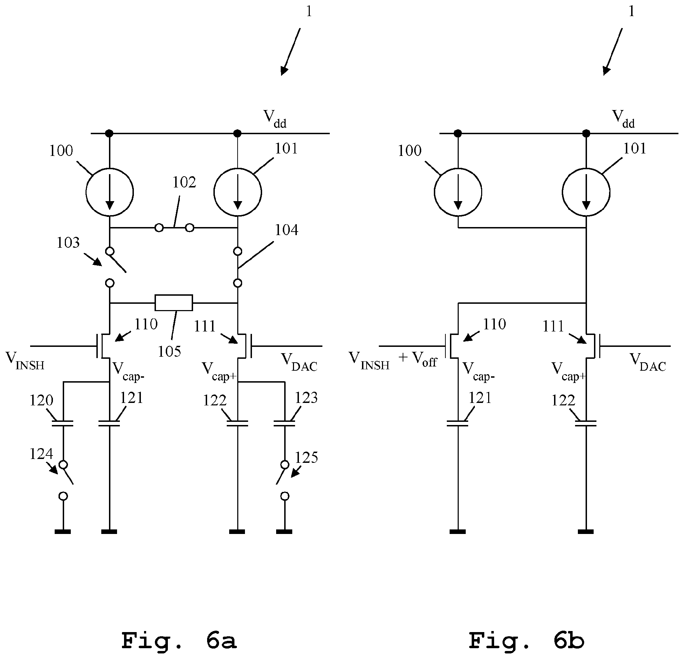

The offset device 10 is configured to generate an offset signal V_{off} and either add or subtract this offset signal to the first input signal V_{INSH}. In a first operating mode, the offset signal V_{off} is added to the first input signal V_{INSH}. In a second operating mode, the offset signal V_{off} is subtracted from the first input signal V_{INSH}. In a third operating mode, no offset is added to the first input signal V_{INSH}. With regard to the different operating modes, further elaborations will be made with regard to Fig. 6a -8b.

In Fig. 3, a circuit diagram of an embodiment of the inventive comparator is shown. Especially, here, the offset device 10, the differential amplifier 11 and the capacitor device 12 are shown.

The offset device 10 is comprised of two current sources 100, 101, both connected to a supply voltage V_{dd} on one side. Moreover, the offset device 10 comprises offset switches 102, 103 and 104 in a Pi-configuration. The offset switch 102 connects the respective second sides of the current sources 100, 101. The offset switches 103, 104 connect the respective second sides of the current sources 100, 101 to the differential amplifier 11. The offset device moreover comprises an offset resistor 105. The resistor 105 connects the offset switches 103, 104 on their current source opposite sides.

The differential amplifier 11 comprises a first amplifier transistor 110 and a second amplifier transistor 111. A current path of the first amplifier transistor 110 is connected to the offset switch 103. A current path of the second amplifier transistor 111 is connected to the offset switch 104. A control terminal of the first amplifier transistor 110 is connected to the first input signal. A control terminal of the second amplifier transistor 111 is connected to the second input signal. The opposite sides of the current paths of the first amplifier transistor 110 and the second amplifier transistor 111 are connected to the capacitor device 12.

The capacitor device 12 comprises capacitors 120, 121, 122 and 123. The capacitor 120 is connected between the first amplifier transistor 110 and a switch 124. The switch 124 is connected to ground on its second side. The capacitor 121 is directly connected between the first amplifier transistor 110 and ground. The capacitor 122 is directly connected between the second amplifier transistor 111 and ground. The capacitor 123 is connected between the second amplifier transistor 111 and a capacitor switch 125, which is connected to ground on its second side. The capacitors 121, 122 form a first capacitor pair, while the capacitors 120, 123 form a second capacitor pair.

In general, the amplifier transistors 110, 111 amplify a difference V_{DIFF} between their respective input signals and accordingly charge the capacitors 120 - 123 of the capacitor device 12. At the connection points of the amplifier transistors 110, 111 and the capacitor device 12, a differential capacitor voltage V_{cap+}, V_{cap-} is output.

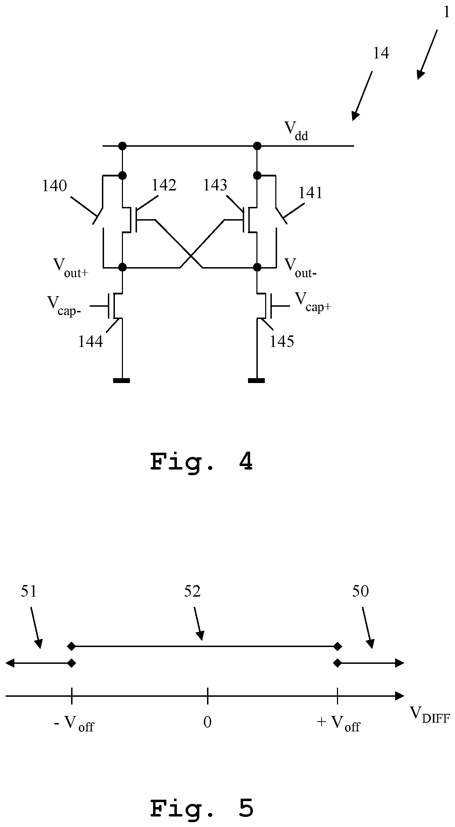

In Fig. 4 a circuit diagram if the latch 14 is shown. A pair of first latch transistors 142 and 143 are connected to supply voltage V_{dd} on one side of their current paths and to a pair of second latch transistors 144, 145 on a second side of their current paths. The second pair of latch transistors 144, 145 are connected to the second side of the current paths of the first latch transistors 142, 143 with a first side of their respective current paths. With a second side of their current paths, they are connected to ground. The connection points of the first latch transistors 142, 143 and the second latch transistors 144, 145 are fed back as crossed control inputs of the first latch transistors 142, 143. This means that the connection point of the latch transistor 142 and the latch transistor 144 is fed back to the control input of the latch transistor 143, and the connection point of the latch transistor 143 and the latch transistor 145 is fed back to the control input of the latch transistor 142. Parallel to the first latch transistor pair 142, 143, is a a reset switch pair 140, 141.

The differential capacitor voltage V_{cap+}, V_{cap-} is supplied as control signal to the second latch transistor pair 144, 145, while the reset switches 140, 141 are opened. As soon as the absolute value of either of the capacitor voltages V_{cap+}, V_{cap-} forming the differential capacitor voltage V_{cap+} - V_{cap-} exceeds a latch threshold, the latch latches, and at the connection points of the first latch transistors 142, 143 and the second latch transistors 144, 145 a differential latch output voltage Vₒᵤₜ₊, Vₒᵤₜ₋ is output. After each read out of the differential latch output voltage Vₒᵤₜ₊, Vₒᵤₜ₋, the reset switches are engaged briefly, to reset the latch 14. This is controlled e.g. by the controller 13 of Fig. 2.

With regard to the function of the circuits of Fig. 3 and Fig. 4 in the different operating modes, it is referred to later elaborations with regard to Fig. 6a - 8b.

In Fig. 5, a voltage diagram of the difference voltage V_{DIFF} between the first input signal and the second input signal are shown. Especially, different voltage areas defined by the positive and negative offset voltage are shown.

If the first input signal is larger than the second input signal, the difference voltage V_{DIFF} is positive. If the second input signal is larger than the first input signal, the difference voltage V_{DIFF} is negative.

If the difference voltage has a relatively small value, noise is of high importance, since noise can change the amplification result, and therefore the decision which of the input values is larger. This is the case in voltage region 52. On the other hand, if the difference value V_{DIFF} has a relatively large value, noise is less relevant, since to a high probability, it cannot change the amplification result and therewith the decision, which input value is larger. This is the case in the voltage regions 51 and 50.

According to the present invention, these two different situations are handled differently. In the case of a high difference value V_{DIFF}, a low capacitance value is used. This results in a high-noise susceptibility, but at the same time at a low power consumption. The high-noise susceptibility is unproblematic, since the difference value is so large that it cannot be exceeded by the noise to a high degree of probability.

In case of a low difference value V_{DIFF}, a high-noise susceptibility is the case. In this case, a high capacitance value is used. This results in a high power consumption, but reduces noise susceptibility.

This is exemplified in Fig. 5, where the difference value V_{DIFF} as well as a positive and negative offset voltage V_{off} are displayed. When the difference voltage is in the voltage region 50, even larger than the positive offset value V_{off}, a low-noise susceptibility is assumed. If the difference voltage V_{DIFF} is in the voltage region 51, even smaller than the negative offset voltage -V_{OFF}, a low-noise susceptibility is assumed. Only if the difference voltage V_{DIFF} is in a voltage region 52 between the negative offset voltage -V_{off} and the positive offset voltage V_{off}, a high-noise susceptibility is assumed.

In Fig. 6a, the inventive comparator 1 is shown in a first operating mode. In this first operating mode, the offset switches 102 and 104 are closed, while the offset switch 103 is open. Both bias currents of the current sources 100, 101 flow through the offset switch 104. By means of the resistor 105, an additional virtual offset voltage V_{off} results at the control terminal of the first amplifier transistor 110. In this first operating mode, the capacitor switches 124, 125 are open, resulting in the capacitors 120, 123 not participating in the circuit. The resulting equivalent circuit diagram can be seen in Fig. 6b.

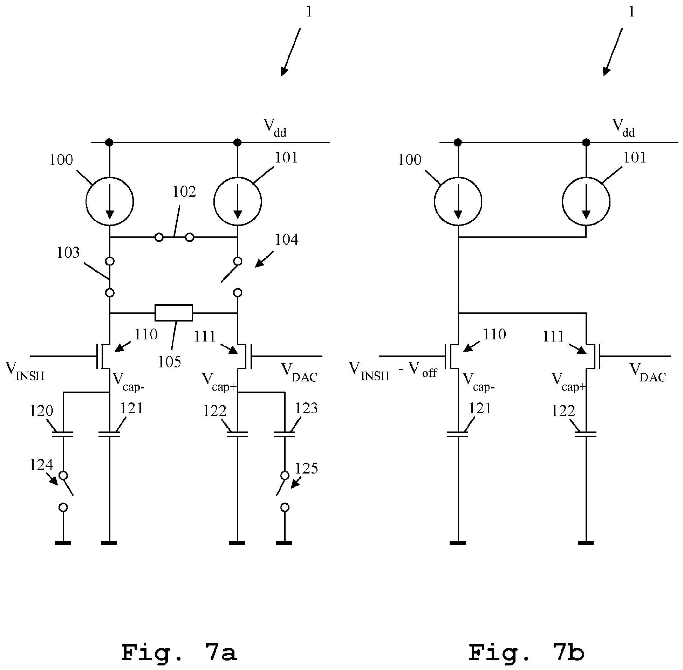

In Fig. 7a, the inventive comparator 1 is shown in a second operating mode. Here, the offset switches 102, 103 are closed, while the offset switch 104 is open. This results in the currents of both current sources 100, 101, flowing through the offset switch 103. By means of the resistor 105, a virtual subtraction of an offset voltage V_{off} from the first input signal is achieved.

Also, in this second operation mode, the capacitor switches 124, 125 are open, resulting in the capacitors 120, 123 not participating in the circuit. In the first operating mode and in the second operating mode, the capacitance of the capacitor device 12 is thereby only set by the capacitors 121, 122, resulting in a first capacitor value. The equivalent circuit diagram is shown in Fig. 7b.

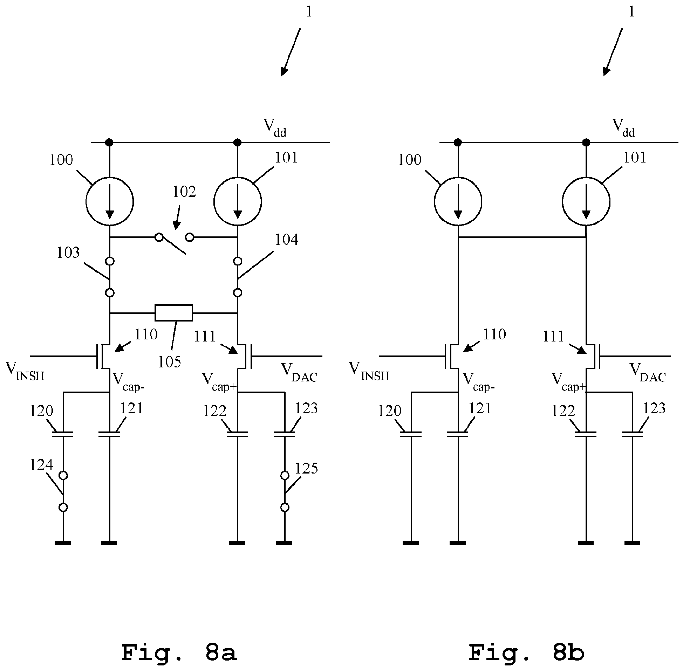

In Fig. 8a, a third operating mode of the inventive comparator 1 is shown. Here, the offset switches 103, 104 are closed, while the offset switch 102 is open. This results in both bias currents flowing each towards a different one of the amplifier transistors 110, 111. The bias currents therefore cancel each other out. This can also be explained as no bias current flowing through the offset resistor 105, resulting in no offset voltage occurring.

In this third operating mode, the capacitor switches 124, 125 are closed, resulting in the capacitors 120, 123, being connected in parallel to the capacitors 121/122. This results in an increased second capacitor value in the third operating mode. An equivalent circuit to the circuit of Fig. 8a is shown in Fig. 8b.

The different operating modes are further elaborated on with regard to the flow diagram of Fig. 9. It is important to note that all elaborations with regard to the inventive comparator are also applicable to the inventive method and vice versa.

In Fig. 9, a flow diagram of the inventive method is shown. In a first step 200, a first, low comparison capacitance is set. This is achieved, as shown in Fig. 6a and 7a, by opening the capacitor switches 124, 125.

In a second step 201, a positive offset is input. This is achieved, as shown in Fig. 6a, by closing the offset switches 102, 104 and opening the offset switch 103. This corresponds to the first operating mode, explained earlier.

In a third step 202, an output value of the differential amplifier is determined. This is done by reading out the differential latch output signal Vₒᵤₜ₊ - Vₒᵤₜ₋, which is output by the latch 14 in reaction to the differential capacitor voltage V_{cap+} - V_{cap-}. The latch 14 therein triggers when the voltage of any of the capacitor voltages V_{cap+}, V_{cap-} forming the differential capacitor voltage V_{cap+}, V_{cap-} reaches the triggering threshold of the latch 14. Then the latch 14 output shows a large differentially positive or negative value Vₒᵤₜ₊ - Vₒᵤₜ₋ based on the differential output of the amplifier 11, stored in the capacitor device 12.

In a fourth step 203, it is determined, if V_{INSH} + V_{OFF} < V_{DAC}. This is done by checking the value Vₒᵤₜ₊ - Vₒᵤₜ₋. This is the case, when Vₒᵤₜ₊ - Vₒᵤₜ₋ is negative. If Vₒᵤₜ₊ - Vₒᵤₜ₋ is negative, then V_{INSH} + V_{OFF} < V_{DAC}.

If V_{INSH} + V_{OFF} < V_{DAC}, the method is terminated with the result that the first input signal V_{INSH} is smaller than the second input signal V_{DAC} in a step 210.

If V_{INSH} + V_{OFF} > V_{DAC}, then the method is continued in a fifth step 204, where a negative offset is input. This corresponds to the second operating mode explained earlier. The switches are set as can be seen in Fig. 7a.

In a sixth step 205, again the output value is determined, as explained with regard to step 202. In a seventh step 206, it is checked if the first input value V_{INSH} minus the offset voltage V_{off} is larger than the second input value. If this is the case, the comparison is terminated with the result that the first input value is larger than the second input value in a step 211. If this is not the case, it is determined that the difference voltage V_{DIFF} lies in the voltage region 52 of Fig. 5. In this case, a third operating mode with a high-power consumption is necessary.

Such a high comparison capacitance is set in an eighth step 207. The switches are set as can be seen in Fig. 8a. Now, all four capacitors 120-123 participate in the circuit, resulting in a high comparison capacitance. Again, in a step 208, the output value is determined, as explained with regard to step 202. Now, in a tenth step 209, a final check is performed, what value the voltage Vₒᵤₜ₊ - Vₒᵤₜ₋ has, and therefore which input value is larger. If V_{INSH} is larger than V_{DAC}, the comparison is terminated with this result in a step 212. If V_{INSH} is not larger than V_{DAC}, the comparison is terminated with the result that the first input signal is smaller than the second input signal in a step 213.

The invention is not limited to the examples and especially not to specific offset values and capacitor values. Also, a use of more than two different offset values and more than two different capacitor values is possible. In this case, a comparison of the difference voltage to a plurality of different offset values and an according setting of different capacitor levels is possible. The characteristics of the example embodiments can be used in any advantageous combination.

While various embodiments of the present invention have been described above, it should be understood that they have been presented by way of example only, and not limitation. Numerous changes to the disclosed embodiments can be made in accordance with the disclosure herein without departing from the spirit or scope of the invention. Thus, the breadth and scope of the present invention should not be limited by any of the above described embodiments. Rather, the scope of the invention should be defined in accordance with the following claims and their equivalents.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. Comparator (1) for comparing a first input signal (V_{INSH}) to a second input signal (V_{DAC}), comprising:
- a differential amplifier (11), adapted to amplify a difference (V_{DIFF}) between a first amplifier signal and a second amplifier signal, and
- a capacitor device (12), adapted to charge to a differential capacitor voltage (V_{cap+} - V_{cap-}) based upon the amplified difference between the first amplifier signal and the second amplifier signal,
**characterized in that**
the capacitor device (12) comprises an adaptive capacitance (120, 121, 122, 123).

2. Comparator (1) according to claim 1,
wherein the first amplifier signal is the first input signal (V_{INSH}) or a signal based on the first input signal (V_{INSH}), and
wherein the second amplifier signal is the second input signal (V_{DAC}) or a signal derived from the second input signal (V_{DAC}).

3. Comparator (1) according to claim 1 or 2, comprising a latch (14), connected to the differential amplifier (11), adapted to
- trigger, when an absolute value of either of capacitor voltages (V_{cap+}, V_{cap-}) forming the differential capacitor voltage (V_{cap+} - V_{cap-}) exceeds a trigger threshold, and
- after triggered, indicate with a differential latch output signal (Vₒᵤₜ₊ - Vₒᵤₜ₋) if the differential capacitor voltage (V_{cap+} - V_{cap-}) , was positive or negative.

4. Comparator (1) according to claim 3,
wherein the differential amplifier (11) is adapted to charge the capacitor device to
- a positive differential capacitor voltage (V_{cap+} - V_{cap-}), if the first pre-amplifier signal is larger than the second pre-amplifier signal, and
- a negative differential capacitor voltage (V_{cap+} - V_{cap-}), if the second pre-amplifier signal is larger than the first pre-amplifier signal, and
wherein the latch (14) is adapted to
- output a positive differential latch output signal (Vₒᵤₜ₊ - Vₒᵤₜ₋) , if the differential capacitor voltage (V_{cap+} - V_{cap-}) is positive and if the absolute value of either of the capacitor voltages (V_{cap+}, V_{cap-}) is above the trigger threshold, and
- output a negative differential latch output signal (Vₒᵤₜ₊ - Vout-), if the differential capacitor voltage (V_{cap+} - V_{cap-}) is negative and if the absolute value of either of the capacitor voltages (V_{cap+}, V_{cap-}) is above the trigger threshold.

5. Comparator (1) according to any of the claims 1 to 4,
wherein the comparator (1) comprises an offset device (10), adapted to provide an offset signal (V_{off}) to the differential amplifier (11).

6. Comparator (1) according to claim 5,
wherein, in a first operation mode,
- the capacitor device (12) is adapted to set the adaptive capacitance (120, 121, 122, 123) to a first value,
- the offset device (10) is adapted to add the offset signal (V_{off}) to the first input signal (V_{INSH}), resulting in the first amplifier signal, and
- the comparator (1) is adapted to output a negative output signal (V_{COMP}), if the differential latch output signal (Vₒᵤₜ₊ - Vₒᵤₜ₋) is negative.

7. Comparator (1) according to claim 6,
wherein, in the first operation mode,
- the comparator (1) is adapted to enter a second operation mode, if the differential latch output signal (Vₒᵤₜ₊ - Vₒᵤₜ₋) is positive, and
wherein in the second operation mode,
- the capacitor device (12) is adapted to set the adaptive capacitance to the first value,
- the offset device (10) is adapted to subtract the offset signal (V_{off}) from the first input signal (V_{INSH}), resulting in the first amplifier signal, and
- the comparator (1) is adapted to output a positive output signal (V_{COMP}), if the differential latch output signal (Vₒᵤₜ₊ - Vₒᵤₜ₋) is positive.

8. Comparator (1) according to claim 7,
wherein in the second operation mode,
- the comparator (1) is adapted to enter a third operation mode, if the differential latch output signal (Vₒᵤₜ₊ - Vₒᵤₜ₋) is negative, and
wherein in the third operation mode,
- the capacitor device (12) is adapted to set the adaptive capacitance (120, 121, 122, 123) to a second value, larger than the first value,
- the offset device (10) is adapted to provide the offset signal (V_{off}), so that it cancels out, resulting in the first amplifier signal being the first input signal (V_{INSH}), and
- the comparator (1) is adapted to output a positive output signal (V_{COMP}), if the differential latch output signal (Vₒᵤₜ₊ - Vₒᵤₜ₋) is positive, and
- the comparator (1) is adapted to output a negative output signal (V_{COMP}), if the differential latch output signal (Vₒᵤₜ₊ - Vₒᵤₜ₋) is negative.

9. Comparator (1) according to claim 8,
wherein, in the third operation mode, the capacitor device (12) is adapted to set the adaptive capacitance to a second value, larger by at least 50%, preferably 100%, most preferably 200%, than the first value.

10. Comparator (1) according to any of the claims 1 to 9,
wherein the capacitor device (12) comprises at least a first capacitor (121, 122), at least a second capacitor (120, 123), and at least a switch (124, 125), and
wherein the capacitor device (12) is adapted to change its capacity between a first value and a second value by opening and closing the at least one switch (124, 125).

11. Comparator (1) according to any of the claims 5 to 10,
wherein the offset device (10) comprises
- a first current source (100), adapted to input a first bias current,
- a second current source (101), adapted to input a second bias current, the second bias current being of an identical value as the first bias current,
- at least one offset switch (102, 103, 104), and
- at least one offset resistor (105), and
wherein the offset device (10) is adapted to selectively produce:
- a positive offset signal,
- a negative offset signal, and
- a canceled out offset signal.

12. Comparator (1) according to claim 11,wherein the offset device (10) is adapted to:
∘ in the first operating mode, provide the first bias current and the second bias current to the differential amplifier (11), both in a first direction, resulting in the offset signal (V_{off}) being added to the first input signal (V_{INSH}), resulting in the positive offset signal (+V_{off}),
∘ in the second operating mode, provide the first bias current and the second bias current to the differential amplifier (11), both in a second direction, resulting in the offset signal (Voff) being subtracted from the first input signal (V_{INSH}), resulting in the negative offset signal (-V_{off}), and
∘ in the third operating mode, provide the first bias current to the differential amplifier (11) in the first direction, and provide the second bias current to the differential amplifier (11) in the second direction, resulting in a voltage drop across the at least one offset resistor of the first bias current and a voltage drop across the at least one offset resistor of the second bias current cancelling each other out, resulting in the canceled out offset signal.

13. Analogue to digital converter (2), comprising a comparator (1) according to any of the claims 1 to 12.

14. Device comprising
an analogue to digital converter according to claim 13, wherein the device is a biomedical sensor device or a mobile communications device.

15. Method for comparing a first input signal (V_{INSH}) to a second input signal (V_{DAC}), comprising:
- amplifying (201, 202) a difference (V_{DIFF}) between a first amplifier signal and a second amplifier signal, and
- charging (201, 202) a capacitor device (12) to a differential capacitor voltage (V_{cap+} - V_{cap-}) based upon the amplified difference between the first amplifier signal and the second amplifier signal,
**characterized by**
adaptively changing (207) a capacitance of the capacitor device (12).
